# EUROPEAN PATENT SPECIFICATION

(11) **EP 3 751 236 B1**
(45) Date of publication and mention of the grant of the patent: **18.10.2023**
(21) Application number: 18904902.6
(22) Date of filing: 27.11.2018
(51) Int. Cl.: G01D 21/00, H01Q 1/38, H01Q 1/40, H05K 7/14

(54) **WIRELESS SENSOR DEVICE AND WIRELESS SENSOR DEVICE KIT**
DRAHTLOSE SENSORVORRICHTUNG UND KIT FÜR DRAHTLOSE SENSORVORRICHTUNG
DISPOSITIF DE TYPE CAPTEUR SANS FIL ET KIT POUR DISPOSITIF DE TYPE CAPTEUR SANS FIL

(30) Priority: 06.02.2018 JP 2018019160
(43) Date of publication of application: 16.12.2020
(73) Proprietor: DIC Corporation, Tokyo 174-8520 (JP)
(72) Inventor: NISHI Hidefumi, Tokyo 103-8233 (JP)
(74) Representative: Beckmann, Claus
(86) International application number: PCT/JP2018/043521
(87) International publication number: WO 2019/155732

(56) References cited:
- WO-A1-2014/125726
- WO-A1-2016/108888
- WO-A2-2006/094513
- JP-A- 2004 523 289
- JP-A- 2008 302 052
- JP-A- 2008 532 596
- JP-A- 2010 251 706
- JP-A- 2015 129 731
- JP-A- 2015 530 225
- US-A1- 2008 225 395
- US-A1- 2015 019 024
- US-A1- 2016 006 123
- MOINUDDIN AHMED ET AL: "Temperature Sensor in a Flexible Substrate", IEEE SENSORS JOURNAL, IEEE SERVICE CENTER, NEW YORK, NY, US, vol. 12, no. 5, 1 May 2012 (2012-05-01), pages 864-869, XP011440774, ISSN: 1530-437X, DOI: 10.1109/JSEN.2011.2166064

## Description

### Technical Field

The present invention relates to wireless sensor devices for installation in locations such as buildings.

### Background Art

To reduce energy consumption while maintaining comfort in buildings, there are sensor devices that sense environmental conditions such as temperature, humidity, and illuminance and provide the results for use in, for example, controlling air conditioners. Such sensor devices can be used in buildings to provide information necessary for optimum control of cooling, heating, ventilation, air conditioning, and illumination systems to more efficiently control the amount of energy used in buildings.

Because the installation and wiring costs of conventional sensors are very high, wireless sensor devices have been proposed to reduce the cost involved in wiring, particularly when large numbers of advanced sensors are introduced into existing buildings. Wireless sensor devices are suitable for easy renovation of existing buildings and offer flexibility in that they can be disposed at optimum monitoring sites. Currently marketed wireless sensor devices have a casing composed of a resin case and a printed board are thus made of a hard material with a certain thickness (e.g., 2 cm or more).

PTL 1 discloses a wireless sensor device having a plurality of components disposed on a flexible substrate, including a communications system, at least one sensor device communicatively coupled to the communications system, and at least one antenna electrically coupled to the communications system. PTL 1 also discloses, for example, an example of a wireless sensor device having a solar cell and a secondary battery built thereinto so that the wireless sensor device does not need to have an external power supply connected thereto.

### Citation List

### Patent Literature

PTL 1: Specification of U.S. Patent Application Publication No. 2016/0134327

Document US2016006123A1 discloses a flexible antenna of a flexible device for short-range wireless communication.

### Summary of Invention

### Technical Problem

One possible form of wireless sensor device that does not need to have an external power supply connected thereto is one having a primary battery built thereinto. This form of wireless sensor device, however, requires the replacement of the primary battery and thus has a problem in terms of the effort and cost of the replacement procedure. A form of wireless sensor device that has a solar cell built thereinto and a form of wireless sensor device that has a secondary battery and/or a primary battery built thereinto in addition to a solar cell have a problem in that the mounting of the solar cell and its associated components involves a high cost, and the mounting of the solar cell also degrades the design. Furthermore, a form of wireless sensor device that has only a solar cell built thereinto has a problem with operation in the absence of a light source, such as at nighttime.

Accordingly, an object of the present invention is to provide a wireless sensor device that allows for a reduced mounting cost of a built-in battery and its associated components, simplified effort in a procedure for replacement of the built-in battery or the wireless sensor device, and a reduced cost of the replacement procedure.

### Solution to Problem

The present invention is defined in the appended claims.

### Advantageous Effects of Invention

A casing composed of the flexible circuit board and the flexible sheet of the wireless sensor device according to the present invention can be attached and installed with the first adhesive layer and can also be easily removed. Thus, the wireless sensor device according to the present invention is easier to install and remove than a wireless sensor device having a casing composed of a resin case and a printed board. In addition, because a primary battery is mounted as an internal power supply, the mounting cost of the built-in battery and its associated components can be significantly reduced as compared to a wireless sensor device having a solar cell mounted thereon. Furthermore, because the wireless sensor device is composed of fewer components and therefore its manufacturing costs can be significantly reduced as compared to a wireless sensor device composed of a resin case and a printed board, an increase in cost due to the replacement of the entire wireless sensor device is alleviated. The alleviated cost of the replacement of the entire wireless sensor device and the ease of installation and removal allow for simplified effort in a procedure for replacement of a built-in battery or a wireless sensor device for conventional wireless sensor devices and a reduced cost of the replacement procedure.

### Brief Description of Drawings

[Fig. 1] Fig. 1 is a schematic sectional view illustrating a wireless sensor device 1.
[Fig. 2] Fig. 2 is a schematic plan view of the wireless sensor device 1.
[Fig. 3] Fig. 3 is a schematic view showing that the wireless sensor device 1 is flexible in its entirety.
[Fig. 4] Fig. 4 is a schematic view showing that the entire wireless sensor device 1 can be removed and replaced by a human hand.
[Fig. 5] Fig. 5 is a schematic sectional view illustrating a wireless sensor device 2.
[Fig. 6] Fig. 6 is a schematic view showing that the wireless sensor device 2 can be removed by a human hand for battery replacement.
[Fig. 7] Fig. 7 is a schematic sectional view illustrating a wireless sensor device 3.
[Fig. 8] Fig. 8 is a schematic view illustrating the front and back sides of the wireless sensor device 3 showing that the wireless sensor device 3 can be attached by a human hand.
[Fig. 9] Fig. 9 is a schematic sectional view illustrating a wireless sensor device 4.
[Fig. 10] Fig. 10 is a schematic sectional view illustrating a wireless sensor device 5.
[Fig. 11] Fig. 11 is a schematic sectional view illustrating a wireless sensor device 6.
[Fig. 12] Fig. 12 is a schematic sectional view illustrating a wireless sensor device 7.
[Fig. 13] Fig. 13 is a schematic sectional view illustrating a wireless sensor device 8.
[Fig. 14] Fig. 14 is a schematic sectional view illustrating a wireless sensor device 9.
[Fig. 15] Fig. 15 is a schematic view illustrating a wireless sensor device kit 80 according to a seventh example.
[Fig. 16] Fig. 16 is a schematic view illustrating a wireless sensor device kit 82 according to a modification of the seventh example.
[Fig. 17] Fig. 17 is a schematic sectional view illustrating a wireless sensor device 2' according to a modification of the second example.
[Fig. 18] Fig. 18 is a schematic view showing that the wireless sensor device 2' according to the modification of the second example can be removed by a human hand for battery replacement. Description of Embodiments

Wireless sensor devices according to the present invention will hereinafter be described with reference to the drawings.

For the sake of convenience, the drawings used in the following description may show relevant parts in an enlarged view to facilitate an understanding of the features of the invention, and the dimensional ratios and other details of the individual components are not necessarily the same as those of actual components.

### [First example]

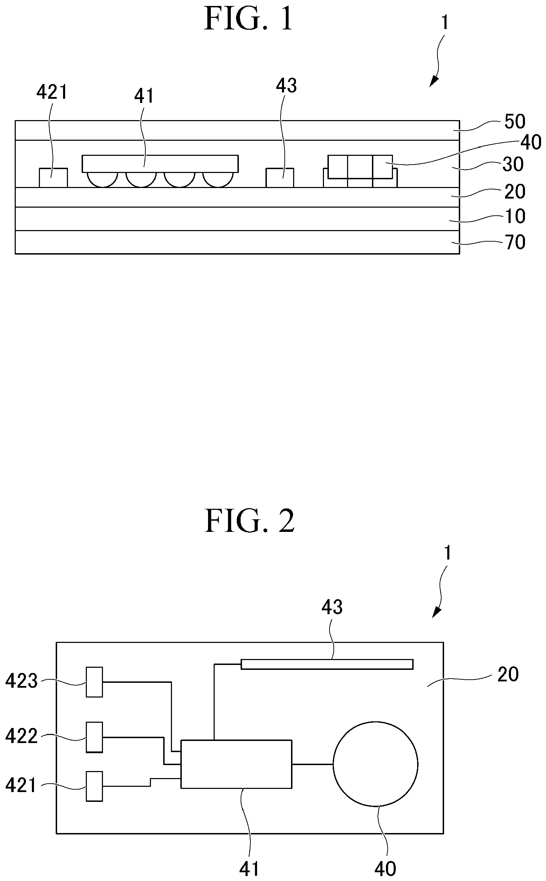

Fig. 1 is a schematic sectional view illustrating a wireless sensor device 1. The wireless sensor device 1 according to the first example includes, on a flexible circuit board 20, a temperature sensor 421, a humidity sensor 422, an illuminance sensor 423, a controller 41 that processes output values received from the temperature sensor 421, the humidity sensor 422, and the illuminance sensor 423, an antenna 43 that wirelessly transmits signals received from the controller 41, and a primary battery 40. An adhesive layer 10, the flexible circuit board 20, and a flexible sheet 50 are stacked together in this order. The temperature sensor 421, the humidity sensor 422, the illuminance sensor 423, the controller 41, the antenna 43, and the primary battery 40 are disposed between the flexible circuit board 20 and the flexible sheet 50.

In Fig. 1, the humidity sensor 422 and the illuminance sensor 423 are not shown. The arrangement of the individual components of the wireless sensor device is not limited. For example, the temperature sensor 421, the humidity sensor 422, the illuminance sensor 423, the controller 41, the antenna 43, and the primary battery 40 may be arranged on the flexible circuit board 20 as shown in Fig. 2. The wireless sensor device may have a release sheet 70. When the wireless sensor device is installed, the release sheet 70 is removed before use. Alternatively, the adhesive layer and the release sheet may be separated from the wireless sensor device in advance and may be attached during the installation of the wireless sensor device.

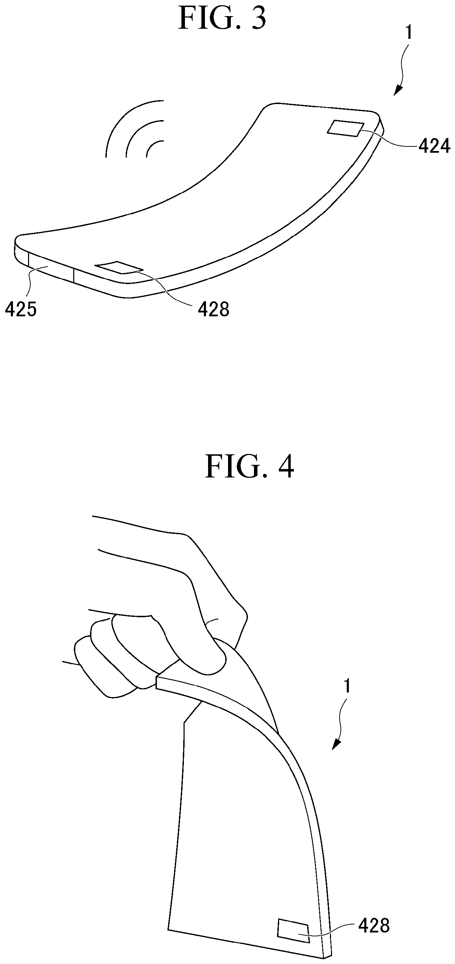

The wireless sensor device 1 according to the first example is compact and thin. As the thinness required to achieve flexibility, it is possible to achieve the thinness corresponding to the sum of the thicknesses of the adhesive layer 10, the flexible circuit board 20, and the flexible sheet 50 in addition to the thicknesses of the various sensors, the controller, and the built-in primary battery. Because the flexible circuit board 20 and the flexible sheet 50, which correspond to a casing, are both flexible, the wireless sensor device 1 is flexible in its entirety, as shown in Fig. 3. The wireless sensor device 1 can be easily installed by removing the release sheet 70 and attaching the wireless sensor device 1 with the adhesive layer 10 to an adherend such as a wall or column of a building. The wireless sensor device 1 also has an outside air window 425. The temperature sensor 421 and the humidity sensor 422 are in communication with the outside air window 425 so that the outside air temperature and humidity can be accurately measured. The wireless sensor device 1 includes an indicator 424. An illuminance sensor small window 428 for proper illuminance measurement is provided at the position of the flexible sheet 50 corresponding to the illuminance sensor 423.

The flexible sheet 50 may be any sheet-shaped material. Examples of materials for the sheet 50 include, but not limited to, polyester-based resins such as polyethylene terephthalate (PET), polyethylene naphthalate (PEN), and polybutylene terephthalate (PBT); vinyl chloride-based resins such as polyvinyl chloride and vinyl chloride copolymers; rubber-based resins; and sponge-like resins.

The flexible circuit board 20 includes a substrate that is composed of an insulating thin, soft base film and a conductive metal such as copper foil attached thereto and that has an electrical circuit formed on the substrate. The flexible circuit board 20 can be fabricated by forming wiring on a base film such as a PET film, a PEN film, or a polyimide film, for example, by printing with a conductive ink.

In addition, the wireless sensor device 1 does not have a solar cell mounted thereon, but has a primary battery mounted thereon as an internal power supply. The primary battery is preferably an inexpensive primary battery distributed in the market, and a coin-type primary battery is suitable for use. Because a flexible casing is selected and the wireless sensor device 1 does not have a solar cell mounted thereon, but has only a primary battery mounted thereon as an internal power supply, the manufacturing costs of the wireless sensor device can be significantly reduced as compared to a wireless sensor device having a casing composed of a resin case and a printed board or a wireless sensor device having a solar cell mounted thereon, and there is no problem with operation in the absence of a light source, such as at nighttime.

The wireless sensor device 1 can be installed by removing the release sheet 70 and attaching the flexible casing with the adhesive layer 10. Because the entire wireless sensor device 1 can be removed and replaced by a human hand, as shown in Fig. 4, the effort and cost of a replacement procedure can be reduced. The wireless sensor device 1 uses a thin built-in primary battery that cannot be replaced, and it is possible to employ a mode of use in which the wireless sensor device 1 is disposed of by removing and replacing the entire main body of the wireless sensor device 1 after use, which eliminates the need for a battery replacement procedure. Because the manufacturing costs of the wireless sensor device 1 can be significantly reduced, an increase in cost due to the replacement of the entire wireless sensor device is alleviated.

The wireless sensor device includes at least one sensor selected from the group consisting of the temperature sensor 421, the humidity sensor 422, the illuminance sensor 423, and other sensors that sense various environmental conditions. The wireless sensor device may include a temperature and humidity sensor that functions both as a temperature sensor and as a humidity sensor. The temperature and humidity sensor may be in communication with the outside air window 425. The temperature sensor 421, the humidity sensor 422, the illuminance sensor 423, other sensors that sense various environmental conditions, the controller 41, and the antenna 43 are electrically coupled together to transmit output values received from the sensors to the controller 41 and to transmit information signals received from the controller 41 to the antenna 43 such that they function as a communication system. The controller 41 incorporates control means for the wireless sensor device to form such a communication system. If the temperature sensor, the humidity sensor, and the illuminance sensor are of a type that can be mounted on IC chips, commercially available thin sensor chips can be used. The information signals received from the sensor chips preferably comply with LPWA standards, which provide wide area coverage with low power consumption. The communication protocol may be, for example, LoRa chirp spread spectrum modulation.

In the wireless sensor device, the antenna 43 wirelessly transmits signals received from the sensors. The material, shape, and method of manufacture of the antenna 43 are not limited as long as it can be disposed on the flexible circuit board and belongs to thin, flat, compact, or ultracompact antennas.

In the wireless sensor device, the first adhesive layer 10 is preferably removable. As the first adhesive layer 10, it is possible to use a commercially available industrial double-sided adhesive tape, more preferably a removable industrial double-sided adhesive tape. The first adhesive layer may be, for example, of a type that has adhesive layers on both sides of a polyester substrate or of a type that has no substrate, i.e., a non-carrier type. Although the first adhesive layer 10 may have removable adhesive surfaces on both sides, it is particularly preferred to use a single-side removable industrial double-sided adhesive tape having a general-purpose adhesive surface on the flexible circuit board 20 side and a removable adhesive surface on the other side. Because the first adhesive layer 10 of the wireless sensor device 1 has a general-purpose adhesive surface on the flexible circuit board 20 side and a removable adhesive surface on the other side, the main body of the wireless sensor device 1 can be attached to, for example, a wall of a building with the first adhesive layer 10 therebetween, and when the wireless sensor device 1 is removed after the wireless sensor device 1 has been used for a long period of time, the wireless sensor device 1 can be easily and cleanly removed without damaging the adherend, for example, a wall paper of a building.

As commercially available industrial double-sided adhesive tapes, for example, DAITAC (registered trademark) manufactured by DIC Corporation can be used. Examples of single-side removable industrial double-sided adhesive tapes include the product codes "#8800DR", "#8612DFT", "#8616DJ-50", and "#8616DJ" Black(N) in the DAITAC (registered trademark) series manufactured by DIC Corporation.

The wireless sensor device 1 includes a protective layer 30 that protects the temperature sensor 421, the humidity sensor 422, the illuminance sensor 423, the controller 41, the antenna 43, and the primary battery 40. The protective layer 30 is disposed between the flexible circuit board 20 and the flexible sheet 50 and is formed of a rubber or sponge material so that the entire wireless sensor device 1 does not lose its flexibility. The protective layer 30 is preferably formed of a flame-retardant rubber or sponge material.

The primary battery 40 is preferably thin. The primary battery 40 is preferably a coin-type primary battery such as a coin-type manganese dioxide lithium battery because of its availability at low cost.

After the wireless sensor device is installed in a building, temperature information obtained from sensing by the temperature sensor, humidity information obtained from sensing by the humidity sensor, and illuminance information obtained from sensing by the illuminance sensor can be wirelessly transmitted via the antenna 43 to a building facility management system. By providing a cooling and heating system, a ventilation and air conditioning system, and an illumination system with information necessary for optimum control, the information can be used to more efficiently control the amount of energy used in the building.

To alleviate the operating costs of the wireless sensor device according to the present invention, it is important to extend the duration of the primary battery. Accordingly, the controller 41 incorporates control means for adjusting the sensing timing and the transmission timing to reduce power consumption and thereby extend the duration of the built-in primary battery. The control means incorporated in the controller 41 may be set to, for example, (1) reduce the transmission frequency of sensor data (i.e., extend the transmission interval) in a dark environment in a location such as an office, or (2) reduce the measurement frequency of a sensor with high power consumption (e.g., the humidity sensor) as compared to other sensors (e.g., the temperature sensor). Thus, the duration of the primary battery can be extended, thereby alleviating the operating costs.

### [Second example]

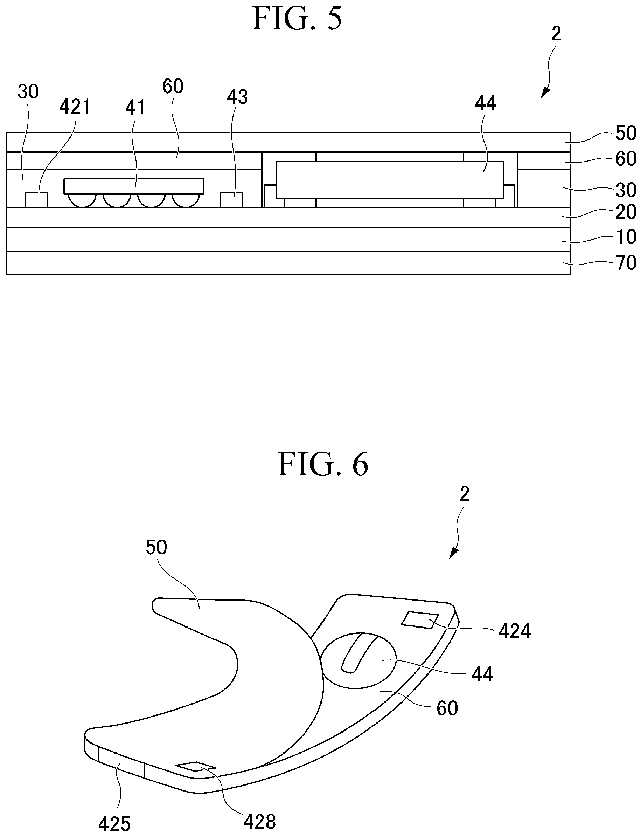

Fig. 5 is a schematic sectional view illustrating a wireless sensor device 2 according to a second example. In Fig. 5 and the subsequent figures, the same components as those shown in the figures that have already been described are denoted by the same reference numerals as those in the figures that have been described, and a detailed description thereof is omitted.

The wireless sensor device 2 according to the second example includes, on a flexible circuit board 20, a temperature sensor 421, a humidity sensor 422, an illuminance sensor 423, a controller 41 that processes output values received from the temperature sensor 421, the humidity sensor 422, and the illuminance sensor 423, an antenna 43 that wirelessly transmits signals received from the controller 41, and a coin-type primary battery 44. An adhesive layer 10, the flexible circuit board 20, a removable second adhesive layer 60, and a flexible sheet 50 are stacked together in this order. The temperature sensor 421, the humidity sensor 422, the controller 41, the antenna 43, and the coin-type primary battery 44 are disposed between the flexible circuit board 20 and the flexible sheet 50. The primary battery 44 can be replaced by removing the flexible sheet 50. In Fig. 5, the humidity sensor and the illuminance sensor are not shown. The wireless sensor device 2 according to the second embodiment has an outside air window 425. The temperature sensor 421 and the humidity sensor 422 are in communication with the outside air window 425 so that the outside air temperature and humidity can be accurately measured. The wireless sensor device 2 according to the second embodiment may include a temperature and humidity sensor that functions both as a temperature sensor and as a humidity sensor, and the temperature and humidity sensor may be in communication with the outside air window 425. An illuminance sensor small window 428 for proper illuminance measurement is provided at the position of the flexible sheet 50 corresponding to the illuminance sensor 423.

The wireless sensor device 2 according to the second example is also compact and thin. Because the flexible circuit board 20 and the flexible sheet 50, which correspond to a casing, are both flexible, the wireless sensor device 2 is flexible in its entirety. The wireless sensor device 2 can be easily installed by removing the release sheet 70 and attaching the wireless sensor device 2 with the adhesive layer 10 to an adherend such as a wall or column of a building.

The wireless sensor device 2 does not have a solar cell mounted thereon, but has the coin-type primary battery 44 mounted thereon as an internal power supply. Because a flexible casing is selected and the wireless sensor device 2 does not have a solar cell mounted thereon, but has only a coin-type primary battery mounted thereon as an internal power supply, the manufacturing costs of the wireless sensor device can be significantly reduced as compared to a wireless sensor device having a casing composed of a resin case and a printed board or a wireless sensor device having a solar cell mounted thereon, and there is no problem with operation in the absence of a light source, such as at nighttime.

As the second adhesive layer, a commercially available removable industrial double-sided adhesive tape can be used. Although the second adhesive layer may have removable adhesive surfaces on both sides, it is more preferred to use a single-side removable industrial double-sided adhesive tape, which has a removable adhesive surface on only one side. The second adhesive layer may be, for example, of a type that has adhesive layers on both sides of a polyester substrate or of a type that has no substrate, i.e., a non-carrier type. Although the second adhesive layer may have a removable adhesive surface on either side, the second adhesive layer 60 has a general-purpose adhesive surface on the flexible circuit board 20 side and a removable adhesive surface on the flexible sheet 50 side. Because a single-side removable double-sided adhesive tape is used as the second adhesive layer 60, the primary battery 44 can be easily replaced.

In addition, the wireless sensor device 2 according to the second example includes, between the flexible circuit board 20 and the second adhesive layer 60, a protective layer 30 that protects the temperature sensor 421, the humidity sensor 422, the illuminance sensor 423, the controller 41, and the antenna 43. As shown in Figs. 5 and 6, the protective layer 30 and the second adhesive layer 60 are hollowed to form a space housing the primary battery 44. This configuration allows a portion of the flexible sheet 50 to be removed from the single-side removable second adhesive layer 60 by a human hand without using a screwdriver or other tool for battery replacement and to be attached again to close the space. Thus, the effort and cost of battery replacement can be reduced.

The controller 41 of the wireless sensor device 2 also incorporates control means for extending the duration of the built-in primary battery. Thus, the duration of the coin-type primary battery 44 can be extended, thereby alleviating the operating costs.

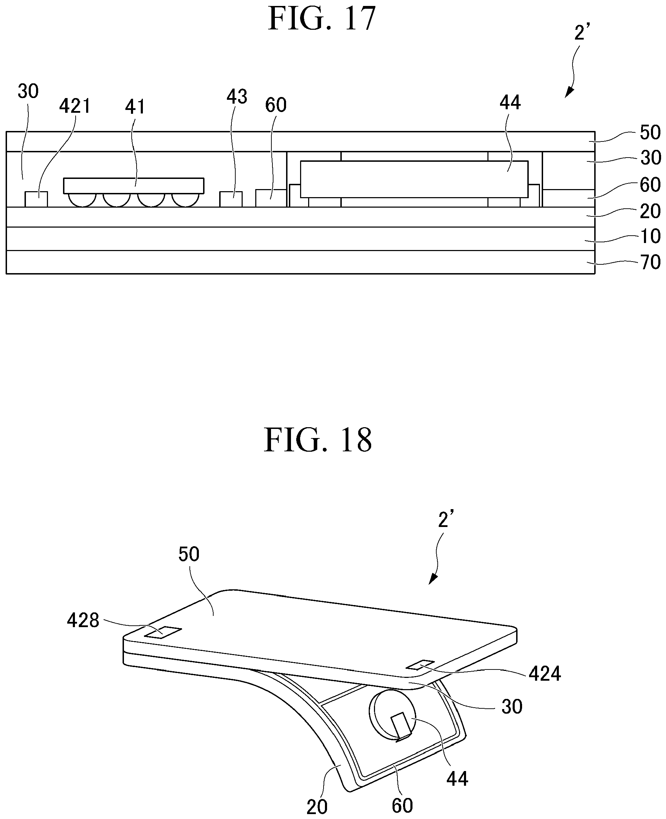

Fig. 17 is a schematic sectional view illustrating a wireless sensor device 2' according to a modification of the second example.

As with the wireless sensor device 2, the wireless sensor device 2 according to the modification of the second example includes, on a flexible circuit board 20, a temperature sensor 421, a humidity sensor, an illuminance sensor, a controller 41, an antenna 43, and a coin-type primary battery 44. An adhesive layer 10, the flexible circuit board 20, and a flexible sheet 50 are stacked together in this order.

The wireless sensor device 2' according to the modification of the second example includes, between the flexible circuit board 20 and the flexible sheet 50, a protective layer 30 that protects the temperature sensor 421, the humidity sensor, the illuminance sensor, the controller 41, and the antenna 43. As shown in Figs. 17 and 18, the protective layer 30 is hollowed to form a space housing the primary battery 44. A removable second adhesive layer 60 is disposed between the flexible circuit board 20 and the protective layer 30 around the coin-type primary battery 44.

The second adhesive layer 60 is of a type that has adhesive layers on both sides of a polyester substrate and has a general-purpose adhesive surface on the flexible circuit board 20 side and a removable adhesive surface on the flexible sheet 50 and protective layer 30 side. Because a single-side removable double-sided adhesive tape is used as the second adhesive layer 60, the primary battery 44 can be easily replaced by removing the flexible circuit board 20 and the second adhesive layer 60 from the flexible sheet 50 and the protective layer 30 around the coin-type primary battery 44.

### [Third Example]

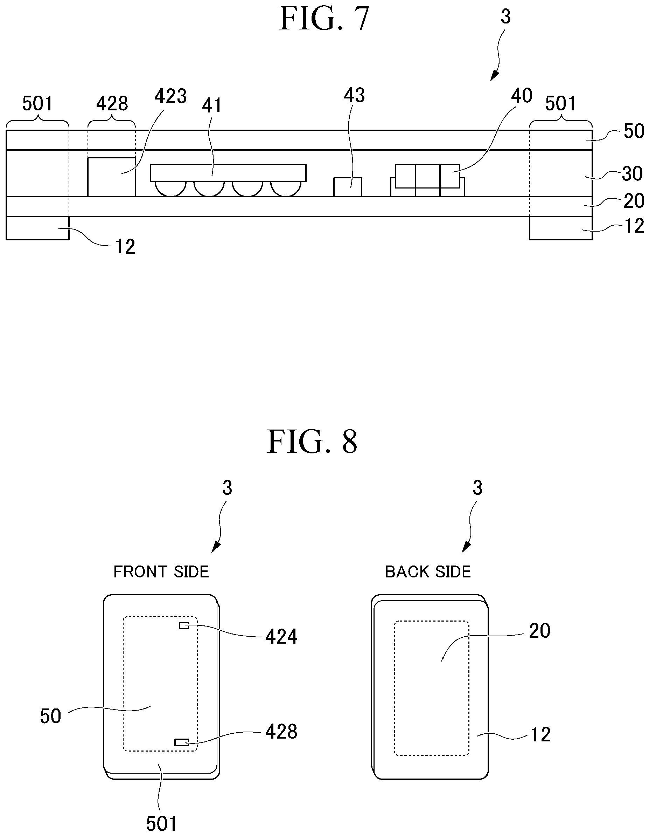

Fig. 7 is a schematic sectional view illustrating a wireless sensor device 3 according to a third example, and Fig. 8 is a schematic view illustrating the front and back sides of the wireless sensor device 3 of the wireless sensor device 3, showing that the wireless sensor device 3 can be attached by a human hand.

The wireless sensor device 3 has an annular pressable region 501 pressable for attachment of the wireless sensor device 3 on the outer periphery of the flexible sheet 50. The pressable region 501 is a region where none of the temperature sensor, the humidity sensor, the illuminance sensor 423, the controller 41, the antenna 43, and the primary battery 40 is mounted. An annular first adhesive layer 12 is disposed only on the pressable region 501. As shown in the left half of Fig. 8, the boundary between the annular pressable region 501 of the flexible sheet 50 and the component mounting region inside the pressable region 501 may be indicated by an annular dotted line, or the pressable region 501 and the component mounting region may be annularly colored in different colors.

When the wireless sensor device 3 is installed by removing the release sheet and attaching the wireless sensor device 3 to an adherend such as a wall or column of a building with the adhesive layer 12, the annular pressable region 501 of the flexible sheet 50 may be pressed by a human hand. Because none of the temperature sensor, the humidity sensor, the illuminance sensor 423, the controller 41, the antenna 43, and the primary battery 40 is mounted in the annular pressable region 501, the likelihood of damage to these mounting components can be reduced.

When the wireless sensor device 3 is removed from an adherend such as a wall or column of a building, the wireless sensor device 3 can be easily removed because the annular first adhesive layer 12 is disposed only on the back side of the pressable region 501 on the outer periphery of the flexible sheet 50 and thus has a bonding area smaller than the entire lower surface of the wireless sensor device. The wireless sensor device 3 also has an illuminance sensor small window 428 for proper illuminance measurement at the position of the flexible sheet 50 corresponding to the illuminance sensor 423.

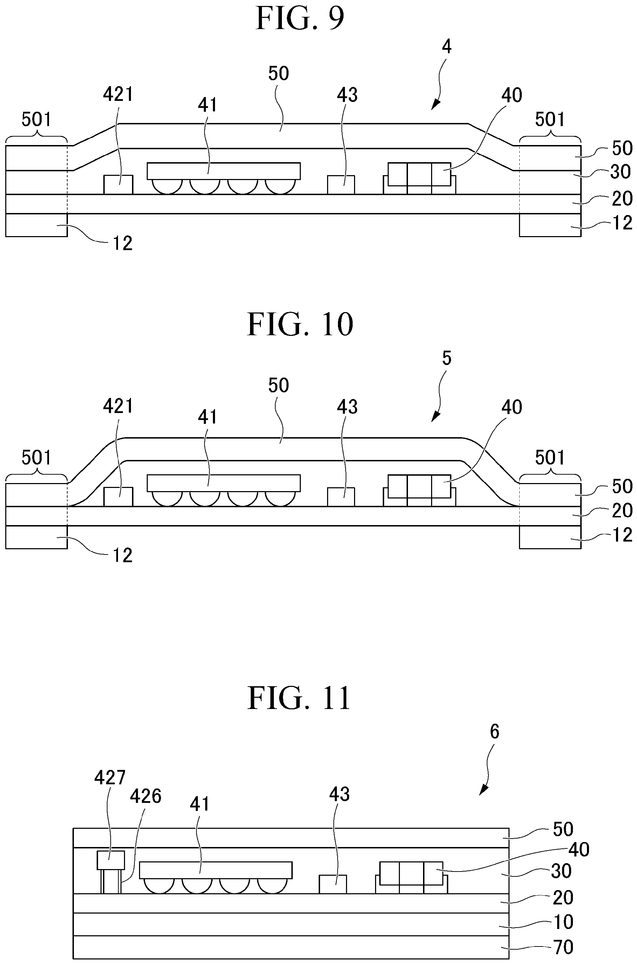

Fig. 9 is a schematic sectional view illustrating a wireless sensor device 4 according to a modification of the third example. As with the wireless sensor device 3, the wireless sensor device 4 has an annular pressable region 501 pressable for attachment of the wireless sensor device 3 on the outer periphery of the flexible sheet 50. An annular first adhesive layer 12 is disposed only on the pressable region 501. The region near the outer periphery of the protective layer 30 is thinner than the inner region, which protects the temperature sensor 421, the humidity sensor, the illuminance sensor, the controller 41, the antenna 43, and the primary battery 40, and also has a slope so that the boundary between the pressable region 501 and the inner component mounting region of the flexible sheet 50 can be easily distinguished by doing the flexible sheet 50. The slope region and the inner component mounting region of the flexible sheet 50 may be colored in different colors, or the pressable region 501 and the component mounting region may be colored in different colors.

Fig. 10 is a schematic sectional view illustrating a wireless sensor device 5 according to a modification of the third example. As with the wireless sensor device 4, the wireless sensor device 5 has a pressable region 501 pressable for attachment of the wireless sensor device 3 on the outer periphery of the flexible sheet 50. An annular first adhesive layer 12 is disposed only on the pressable region 501. The region near the outer periphery of the protective layer 30 is thinner than the inner region, which protects the temperature sensor 421, the humidity sensor, the illuminance sensor, the controller 41, the antenna 43, and the primary battery 40, and also has a slope. In addition, the flexible sheet 50 and the flexible circuit board 20 extend annularly beyond the outer periphery of the protective layer 30. The annular pressable region 501 has a structure in which the flexible sheet 50, the flexible circuit board 20, and the first adhesive layer 12 are directly stacked together.

### [Fourth Example]

Fig. 11 is a schematic sectional view illustrating a wireless sensor device 6 according to a fourth example. The wireless sensor device 6 includes, on a flexible circuit board 20, a temperature and humidity sensor 427 disposed in a floating state with a support member 426 between the temperature and humidity sensor 427 and the flexible circuit board 20, an illuminance sensor 423, a controller 41 that processes output values received from the temperature and humidity sensor 427 and the illuminance sensor 423, an antenna 43 that wirelessly transmits signals received from the controller 41, and a primary battery 40. An adhesive layer 10, the flexible circuit board 20, and a flexible sheet 50 are stacked together in this order. The temperature and humidity sensor 427, the illuminance sensor 423, the controller 41, the antenna 43, and the primary battery 40 are disposed between the flexible circuit board 20 and the flexible sheet 50. Because the temperature and humidity sensor 427 is disposed away from the flexible circuit board 20 with the support member 426 therebetween, the influence of the flexible circuit board 20 can be reduced, and therefore, the temperature and the humidity can be accurately measured. In addition, because the temperature and humidity sensor 427 is disposed away from the flexible circuit board 20 and the adherend with the support member 426 and the adhesive layer 10 therebetween, the influence of the flexible circuit board 20 and the adherend can be reduced, and therefore, the temperature and the humidity can be accurately measured. Furthermore, the wireless sensor device 6 has an outside air window, and the temperature and humidity sensor 427 is in communication with the outside air window so that the outside air temperature and humidity can be accurately measured.

### [Fifth Example]

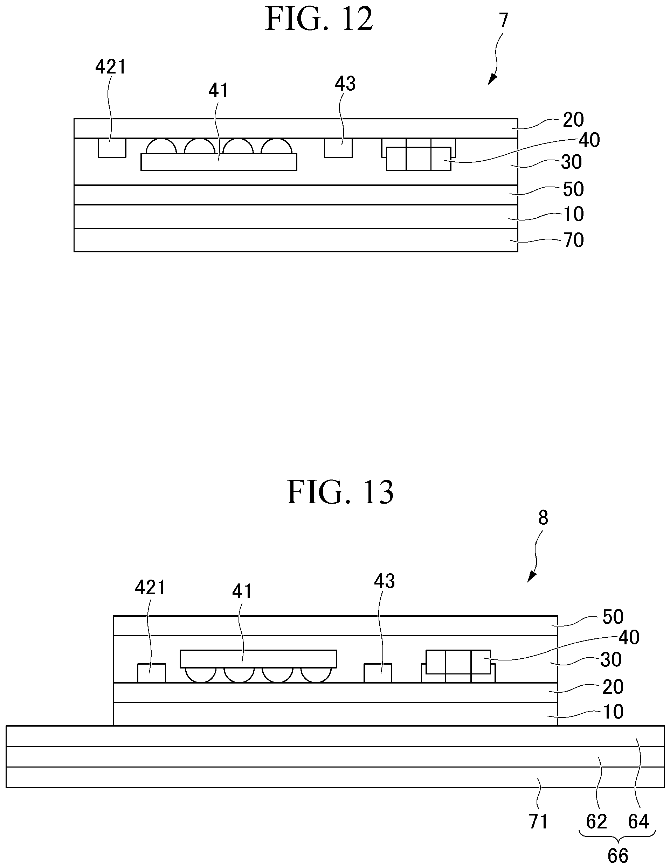

Fig. 12 is a schematic sectional view illustrating a wireless sensor device 7 according to a fifth example. The wireless sensor device 7 includes, on a flexible circuit board 20, a temperature sensor 421, a humidity sensor, an illuminance sensor, a controller 41 that processes output values received from the temperature sensor 421, the humidity sensor, and the illuminance sensor, an antenna 43 that wirelessly transmits signals received from the controller 41, and a primary battery 40. An adhesive layer 10, a flexible sheet 50, and the flexible circuit board 20 are stacked together in this order. The temperature sensor 421, the humidity sensor, the illuminance sensor, the controller 41, the antenna 43, and the primary battery 40 are disposed between the flexible circuit board 20 and the flexible sheet 50. Because the temperature sensor 421 and the humidity sensor are disposed away from the adherend with the flexible sheet 50 and the adhesive layer 10 therebetween, the influence of the adherend can be reduced, and therefore, the temperature and the humidity can be accurately measured.

### [Sixth Example]

A wireless sensor device according to a sixth example further includes an adhesive sheet including a third adhesive layer having a larger bonding area than the first adhesive layer and a substrate sheet. The first adhesive layer is disposed on the back side of the substrate sheet.

Fig. 13 is a schematic sectional view illustrating a wireless sensor device 8 according to the sixth example. The wireless sensor device 8 includes, in addition to the wireless sensor device 1, an adhesive sheet 66 including a third adhesive layer 62 having a larger bonding area than the first adhesive layer 10 and a substrate sheet 64. The first adhesive layer 10 is disposed on the substrate sheet 64 on the back side of the adhesive sheet 66. The substrate sheet 64, the third adhesive layer 62, and the release sheet 71 have the same shape and size. Because the third adhesive layer 62 has a larger bonding area than the first adhesive layer 10, the wireless sensor device 8 can be easily installed by attaching it with the third adhesive layer 62 even if the adherend, such as a wall or column of a building, is unsuitable for bonding, for example, because of antifouling coating.

As the third adhesive layer, it is possible to use a commercially available industrial double-sided adhesive tape, more preferably a removable industrial double-sided adhesive tape. The third adhesive layer may be, for example, of a type that has adhesive layers on both sides of a polyester substrate or of a type that has no substrate, i.e., a non-carrier type. Although the third adhesive layer may have removable adhesive surfaces on both sides, it is particularly preferred that the third adhesive layer have a general-purpose adhesive surface on the flexible circuit board 20 side and a removable adhesive surface on the other side. Thus, when the wireless sensor device 8 is removed from, for example, a wall of a building after the wireless sensor device 8 has been attached for a long period of time, the wireless sensor device 8 can be easily and cleanly removed without damaging the adherend, for example, a wall paper of a building.

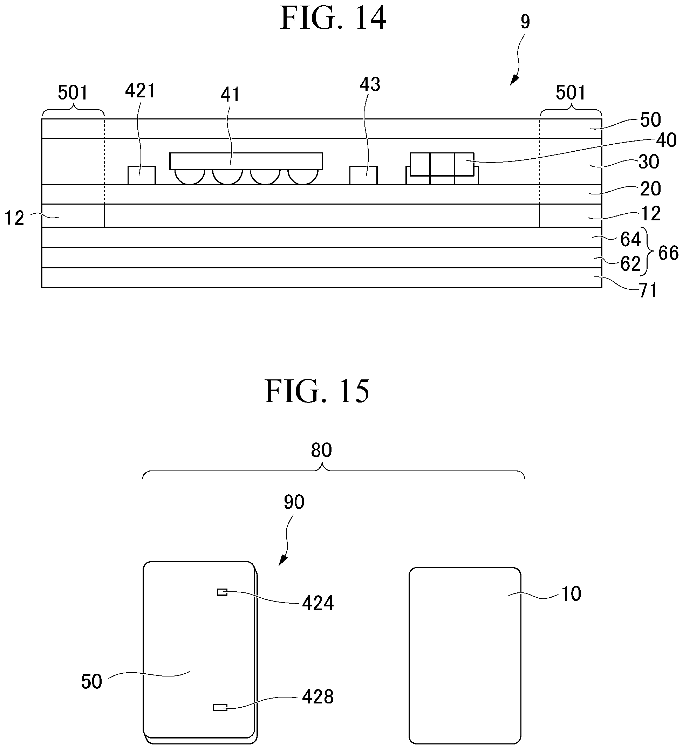

Fig. 14 is a schematic sectional view illustrating a wireless sensor device 9 according to a modification of the sixth example. The wireless sensor device 9 includes, in addition to the wireless sensor device 4, an adhesive sheet 66 including a third adhesive layer 62 having a larger bonding area than the annular first adhesive layer 12 and a substrate sheet 64. The first adhesive layer 12 is disposed on the substrate sheet 64 on the back side of the adhesive sheet 66. The contours of the annular first adhesive layer 12 and the contours of the third adhesive layer 62 have the same shape and size. The substrate sheet 64, the third adhesive layer 62, and the release sheet 71 have the same shape and size. Because the third adhesive layer 62 has a larger bonding area than the first adhesive layer 12, the wireless sensor device 9 can be easily installed by attaching it with the third adhesive layer 62 even if the adherend, such as a wall or column of a building, is unsuitable for bonding, for example, because of antifouling coating.

### [Seventh Example]

A wireless sensor device kit according to a seventh example includes a wireless sensor device including, between a flexible circuit board and a flexible sheet, at least one sensor selected from the group consisting of a temperature sensor, a humidity sensor, an illuminance sensor, and other sensors that sense various environmental conditions, a controller that processes an output value received from the sensor, an antenna that wirelessly transmits a signal received from the controller, and a primary battery; and a first adhesive layer for attaching the wireless sensor device to an adherend.

Fig. 15 is a schematic view illustrating a wireless sensor device kit 80 according to the seventh example. The wireless sensor device kit 80 includes a wireless sensor device 90 including, between a flexible circuit board and a flexible sheet 50, a temperature sensor, a humidity sensor, an illuminance sensor, a controller that processes output values received from the sensors, an antenna that wirelessly transmits signals received from the controller, and a primary battery; and an adhesive layer 10 for attaching the wireless sensor device 90 to an adherend.

The adhesive layer 10 of the wireless sensor device kit 80 is provided, for example, in a form in which the adhesive layer 10 is formed on a heavy release separator and a light release separator is then attached thereto. After the light release separator is removed and the adhesive layer 10 is attached to the wireless sensor device 90, the wireless sensor device 90 is similar to the wireless sensor device 1 according to the first example, the wireless sensor device 2 according to the second example, the wireless sensor device 6 according to the fourth example, or the wireless sensor device 8 according to the sixth example. After the heavy release separator is removed, the wireless sensor device 90 can be attached to the adherend.

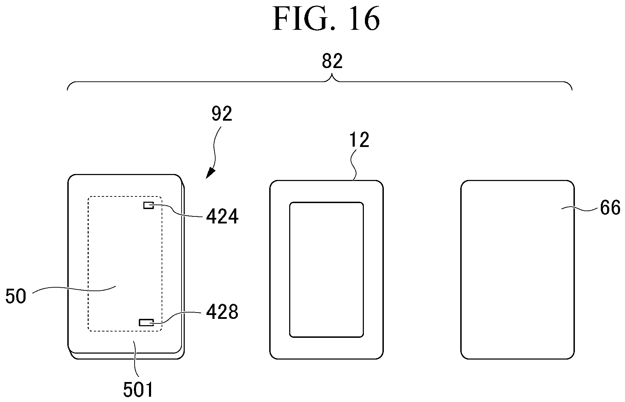

Fig. 16 is a schematic view illustrating a wireless sensor device kit 82 according to a modification of the seventh example. The wireless sensor device kit 82 includes a wireless sensor device 92 including, between a flexible circuit board and a flexible sheet 50, a temperature sensor, a humidity sensor, an illuminance sensor, a controller, an antenna, and a primary battery; an annular first adhesive layer 12 for attaching the wireless sensor device 92 to an adherend; and an adhesive sheet 66 including a third adhesive layer having a larger bonding area than the first adhesive layer 12 and a substrate sheet.

The first adhesive layer 12 of the wireless sensor device kit 82 is provided, for example, in a form in which the first adhesive layer 12 is formed on a heavy release separator and a light release separator is then attached thereto. After the light release separator is removed and the first adhesive layer 12 is attached to the wireless sensor device 92, the wireless sensor device 92 is similar to the wireless sensor device 3, the wireless sensor device 4, or the wireless sensor device 5 according to the third example. After the heavy release separator is removed, the wireless sensor device 92 can be attached to the adherend.

The adhesive sheet 66 of the wireless sensor device kit 82 is provided, for example, in a form in which the third adhesive layer 62 is formed on a heavy release separator and is then attached to the substrate sheet 64. After the heavy release separator is removed from the wireless sensor device 3 according to the third example that has the first adhesive layer 12 attached to the wireless sensor device 92, and the first adhesive layer 12 is attached to the substrate sheet 64 on the back side of the adhesive sheet 66, the wireless sensor device 92 is similar to the wireless sensor device 9 according to the modification of the sixth example. After the heavy release separator (i.e., the release sheet 71) is removed, the wireless sensor device 92 can be attached to the adherend. The wireless sensor device 92 can be easily installed by attaching it with the third adhesive layer 62, which has a larger bonding area, even if the adherend, such as a wall or column of a building, is unsuitable for bonding, for example, because of antifouling coating. The adhesive sheet 66 may be attached to an adherend such as a wall or column of a building in advance, and the wireless sensor device 92 may then be attached to the substrate sheet 64 on the back side of the adhesive sheet 66 with the first adhesive layer 12 therebetween.

The individual configurations, combinations thereof, and other details of the individual embodiments described above are merely illustrative, and additions, omissions, substitutions, and other modifications can be made to the configurations. The present invention is not defined or limited by the individual examples, but is limited only by the scope of the claims.

### Reference Signs List

1, 2, 2', 3, 4, 5, 6, 7, 8, 9 ... wireless sensor device, 10, 12 ... adhesive layer (first adhesive layer), 20, 22 ... flexible circuit board, 30 ... protective layer, 40, 44 ... primary battery, 41 ... controller, 421 ... temperature sensor, 422 ... humidity sensor, 423 ... illuminance sensor, 424 ... indicator, 425 ... outside air window, 426 ... support member, 427 ... temperature and humidity sensor, 428 ... illuminance sensor small window, 43 ... antenna, 50 ... flexible sheet, 501 ... pressable region of flexible sheet, 60 ... removable second adhesive layer, 62 ... third adhesive layer, 64 ... substrate sheet, 66 ... adhesive sheet, 70, 71 ... release sheet, 80, 82 ... wireless sensor device kit, 90, 92 ... wireless sensor device

## Claims

1. A wireless sensor device (2) comprising:
a flexible circuit board (20);
at least one sensor selected from the group consisting of a temperature sensor (421), a humidity sensor (422),
an illuminance sensor (423), and other sensors that sense various environmental conditions;
a controller (41) that processes an output value received from the sensor;
an antenna (43) that wirelessly transmits a signal received from the controller (41);
a replaceable primary battery (44);
a first adhesive layer (10);
a flexible sheet (50);
a removable second adhesive layer (60) between the flexible circuit board (20) and the flexible sheet (50); and
a protective layer (30) that protects the at least one sensor, the controller (41), the antenna (43), and the primary battery (44);
wherein the at least one sensor, the controller (41),
the antenna (43), and the primary battery (44) are on the flexible circuit board (20),
wherein
(a) the first adhesive layer (10), the flexible circuit board (20), and the flexible sheet (50) are stacked together in this order, or
(b) the first adhesive layer (10), the flexible sheet (50), and the flexible circuit board (20) are stacked together in this order,
wherein the at least one sensor, the controller (41), the antenna (43), and the primary battery (44) are disposed between the flexible circuit board (20) and the flexible sheet (50),
wherein the flexible circuit board (20) and the flexible sheet (50) form a casing of the wireless sensor device (2),
wherein the protective layer (30) is disposed between the flexible circuit board (20) and the second adhesive layer (60), and
wherein the protective layer (30) and the second adhesive layer (60) are hollowed to form a space housing the primary battery (44).

2. The wireless sensor device (2) according to Claim 1, wherein the first adhesive layer (10) is removable.

3. The wireless sensor device (2) according to Claim 1 or 2, wherein the primary battery (44) is a coin-type primary battery.

4. The wireless sensor device (2) according to any one of Claims 1 to 3, wherein the controller (41) functions to control a sensing timing of the at least one sensor and a transmission timing of the signal.

5. A wireless sensor device kit (80) comprising:
a wireless sensor device (90) including, between a flexible circuit board (20) and a flexible sheet (50), at least one sensor selected from the group consisting of a temperature sensor (421), a humidity sensor (422), an illuminance sensor (423), and other sensors that sense various environmental conditions, a controller (41) that processes an output value received from the sensor, an antenna (43) that wirelessly transmits a signal received from the controller (41), a primary battery (44), a removable second adhesive layer (60) between the flexible circuit board (20) and the flexible sheet (50), and a protective layer (30) that protects the at least one sensor, the controller (41), the antenna (43), and the primary battery (44); wherein the at least one sensor, the controller (41), the antenna (43), and the primary battery (44) are on the flexible circuit board (20); wherein the protective layer (30) and the second adhesive layer (60) are hollowed to form a space housing the primary battery (44); and
a first adhesive layer (10) for attaching the wireless sensor device to an adherend.

6. The wireless sensor device kit (82) according to Claim 5, further comprising an adhesive sheet (66) including a third adhesive layer (62) having a larger bonding area than the first adhesive layer (10) and a substrate sheet (64) .

## Patentansprüche

1. Funksensorvorrichtung (2), die Folgendes umfasst:
eine flexible Leiterplatte (20);
mindestens einen Sensor, ausgewählt aus der Gruppe, bestehend aus einem Temperatursensor (421), einem Feuchtigkeitssensor (422), einem Beleuchtungsstärkesensor (423) und anderen Sensoren, die verschiedene Umgebungsbedingungen erfassen;
ein Steuergerät (41), das einen von dem Sensor empfangenen Ausgangswert verarbeitet;
eine Antenne (43), die ein vom Steuergerät (41) empfangenes Signal drahtlos überträgt;
eine austauschbare Primärbatterie (44);
eine erste Klebstoffschicht (10);
eine flexible Folie (50);
eine abnehmbare zweite Klebeschicht (60) zwischen der flexiblen Leiterplatte (20) und der flexiblen Folie (50); und
eine Schutzschicht (30), die den mindestens einen Sensor, das Steuergerät (41), die Antenne (43) und die Primärbatterie (44) schützt;
wobei der mindestens eine Sensor, das Steuergerät (41), die Antenne (43) und die Primärbatterie (44) sich auf der flexiblen Leiterplatte (20) befinden,
wobei
(a) die erste Klebeschicht (10), die flexible Leiterplatte (20) und die flexible Folie (50) in dieser Reihenfolge aufeinander gestapelt werden, oder
(b) die erste Klebstoffschicht (10), die flexible Folie (50) und die flexible Leiterplatte (20) in dieser Reihenfolge aufeinander gestapelt werden,
wobei der mindestens eine Sensor, das Steuergerät (41), die Antenne (43) und die Primärbatterie (44) zwischen der flexiblen Leiterplatte (20) und der flexiblen Folie (50) angeordnet sind,
wobei die flexible Leiterplatte (20) und die flexible Folie (50) ein Gehäuse für die Funksensorvorrichtung (2) bilden,
wobei die Schutzschicht (30) zwischen der flexiblen Leiterplatte (20) und der zweiten Klebeschicht (60) angeordnet ist, und
wobei die Schutzschicht (30) und die zweite Klebeschicht (60) ausgehöhlt sind, um einen Raum zu bilden, der die Primärbatterie (44) aufnimmt.

2. Funksensorvorrichtung (2) nach Anspruch 1, wobei die erste Klebeschicht (10) ablösbar ist.

3. Funksensorvorrichtung (2) nach Anspruch 1 oder 2, wobei die Primärbatterie (44) eine Knopfzellen-Primärbatterie ist.

4. Funksensorvorrichtung (2) nach einem der Ansprüche 1 bis 3, wobei das Steuergerät (41) so funktioniert, dass es einen Abtastzeitpunkt des mindestens einen Sensors und einen Übertragungszeitpunkt des Signals steuert.

5. Funksensorvorrichtungs-Kit (80), der Folgendes umfasst:
Eine Funksensorvorrichtung (90), die zwischen einer flexiblen Leiterplatte (20) und einer flexiblen Folie (50) mindestens einen Sensor enthält, ausgewählt aus der Gruppe, bestehend aus einem Temperatursensor (421), einem Feuchtigkeitssensor (422), einem Beleuchtungsstärkesensor (423) und anderen Sensoren besteht, die verschiedene Umgebungsbedingungen erfassen, ein Steuergerät (41), die einen von dem Sensor empfangenen Ausgangswert verarbeitet eine Antenne (43), die ein von dem Steuergerät (41) empfangenes Signal drahtlos überträgt, eine Primärbatterie (44), eine abnehmbare zweite Klebeschicht (60) zwischen der flexiblen Leiterplatte (20) und der flexiblen Folie (50) und eine Schutzschicht (30), die den mindestens einen Sensor, das Steuergerät (41), die Antenne (43) und die Primärbatterie (44) schützt; wobei sich der mindestens eine Sensor, das Steuergerät (41), die Antenne (43) und die Primärbatterie (44) auf der flexiblen Leiterplatte (20) befinden; wobei die Schutzschicht (30) und die zweite Klebeschicht (60) unter Bildung eines Raums, der die Primärbatterie (44) aufnimmt, ausgehöhlt sind ausgehöhlt sind; und
eine erste Klebstoffschicht (10) zum Befestigen der drahtlosen Sensorvorrichtung an einer Klebefläche.

6. Funksensorvorrichtungs-Kit (82) nach Anspruch 5, der ferner eine Klebefolie (66) mit einer dritten Klebeschicht (62), die eine größere Klebefläche als die erste Klebeschicht (10) aufweist, und eine Substratfolie (64) umfasst.

## Revendications

1. Dispositif de type capteur sans fil (2) comprenant :
une carte de circuit imprimé souple (20) ;
au moins un capteur choisi dans le groupe constitué d'un capteur de température (421), un capteur d'humidité (422), un capteur d'éclairement (423) et autres capteurs qui détectent diverses conditions environnementales ;
un dispositif de commande (41) qui traite une valeur de sortie reçue à partir du capteur ;
une antenne (43) qui transmet sans fil un signal reçu à partir du dispositif de commande (41) ;
une batterie principale (44) remplaçable ;
une première couche adhésive (10) ;
une feuille souple (50) ;
une deuxième couche adhésive amovible (60) entre la carte de circuit imprimé souple (20) et la feuille souple (50) ;
et
une couche de protection (30) qui protège l'au moins un capteur, le dispositif de commande (41), l'antenne (43) et la batterie principale (44) ;
dans lequel l'au moins un capteur, le dispositif de commande (41), l'antenne (43) et la batterie principale (44) sont sur la carte de circuit imprimé souple (20),
dans lequel
(a) la première couche adhésive (10), la carte de circuit souple (20) et la feuille souple (50) sont empilées ensemble dans cet ordre, ou
(b) la première couche adhésive (10), la feuille souple (50) et la carte de circuit souple (20) sont empilées ensemble dans cet ordre,
dans lequel l'au moins un capteur, le dispositif de commande (41), l'antenne (43) et la batterie principale (44) sont disposés entre la carte de circuit imprimé souple (20) et la feuille souple (50),
dans lequel la carte de circuit imprimé souple (20) et la feuille souple (50) forment un boîtier du dispositif de type capteur sans fil (2),
dans lequel la couche de protection (30) est disposée entre la carte de circuit imprimé souple (20) et la deuxième couche adhésive (60), et
dans lequel la couche de protection (30) et la deuxième couche adhésive (60) sont évidées pour former un espace logeant la batterie principale (44).

2. Dispositif de type capteur sans fil (2) selon la revendication 1, dans lequel la première couche adhésive (10) est amovible.

3. Dispositif de type capteur sans fil (2) selon la revendication 1 ou 2, dans lequel la batterie principale (44) est une batterie principale plate.

4. Dispositif de type capteur sans fil (2) selon l'une quelconque des revendications 1 à 3, dans lequel le dispositif de commande (41) fonctionne pour commander un moment de détection de l'au moins un capteur et un moment de transmission du signal.

5. Kit de dispositif de type capteur sans fil (80) comprenant :
un dispositif de type capteur sans fil (90) comportant, entre une carte de circuit imprimé souple (20) et une feuille souple (50), au moins un capteur choisi dans le groupe constitué d'un capteur de température (421), un capteur d'humidité (422), un capteur d'éclairement (423) et autres capteurs qui détectent diverses conditions environnementales, un dispositif de commande (41) qui traite une valeur de sortie reçue à partir du capteur, une antenne (43) qui transmet sans fil un signal reçu à partir du dispositif de commande (41), une batterie principale (44), une deuxième couche adhésive amovible (60) entre la carte de circuit souple (20) et la feuille souple (50), et une couche de protection (30) qui protège l'au moins un capteur, le dispositif de commande (41), l'antenne (43), et la batterie principale (44) ; dans lequel l'au moins un capteur, le dispositif de commande (41), l'antenne (43) et la batterie principale (44) sont sur la carte de circuit imprimé souple (20) ; dans lequel la couche de protection (30) et la deuxième couche adhésive (60) sont évidées pour former un espace logeant la batterie principale (44) ; et
une première couche adhésive (10) destinée à fixer le dispositif de type capteur sans fil à une surface adhésive.

6. Kit de dispositif de type capteur sans fil (82) selon la revendication 5, comprenant en outre une feuille adhésive (66) comportant une troisième couche adhésive (62) ayant une zone de liaison supérieure à la première couche adhésive (10) et une feuille de substrat (64).
